Europäisches Patentamt

European Patent Office

Office européen des brevets

(11) Publication number: **0 200 531 B1**

# EUROPEAN PATENT SPECIFICATION

(45) Date of publication of patent specification: **04.08.93**   (51) Int. Cl.⁵: **H01L 27/14**, H01L 31/10, H01L 21/76

(21) Application number: **86303250.4**

(22) Date of filing: **29.04.86**

(54) **Photoelectric conversion device.**

(30) Priority: **30.04.85 JP 91133/85**

(43) Date of publication of application:
**05.11.86 Bulletin 86/45**

(45) Publication of the grant of the patent:
**04.08.93 Bulletin 93/31**

(84) Designated Contracting States:
**DE FR GB NL**

(56) References cited:
**EP-A- 0 132 076**
**DE-A- 3 326 924**
**FR-A- 2 098 323**
**US-A- 3 624 428**

(73) Proprietor: **CANON KABUSHIKI KAISHA**
**30-2, 3-chome, Shimomaruko, Ohta-ku**
**Tokyo(JP)**

(72) Inventor: **Suzuki, Toshiji**
**33-70 Higashi Tamagawagakuen, 1-chome**
**Machida-shi Tokyo(JP)**
Inventor: **Matsumoto, Shigeyuki**
**33-9-501 Asahi-cho 1-chome**
**Atsugi-shi Kanagawa-ken(JP)**

(74) Representative: **Beresford, Keith Denis Lewis**
**et al**
**BERESFORD & Co. 2-5 Warwick Court High**
**Holborn**
**London WC1R 5DJ (GB)**

Rank Xerox (UK) Business Services
(3.10/3.6/3.3.1)

**Description**

BACKGROUND OF THE INVENTION

Field of the Invention

The present invention relates to a photoelectric conversion device having a charge storage region whose potential can be controlled by means of a capacitor and isolation regions according to claims 1 and 10.

Related Background Art

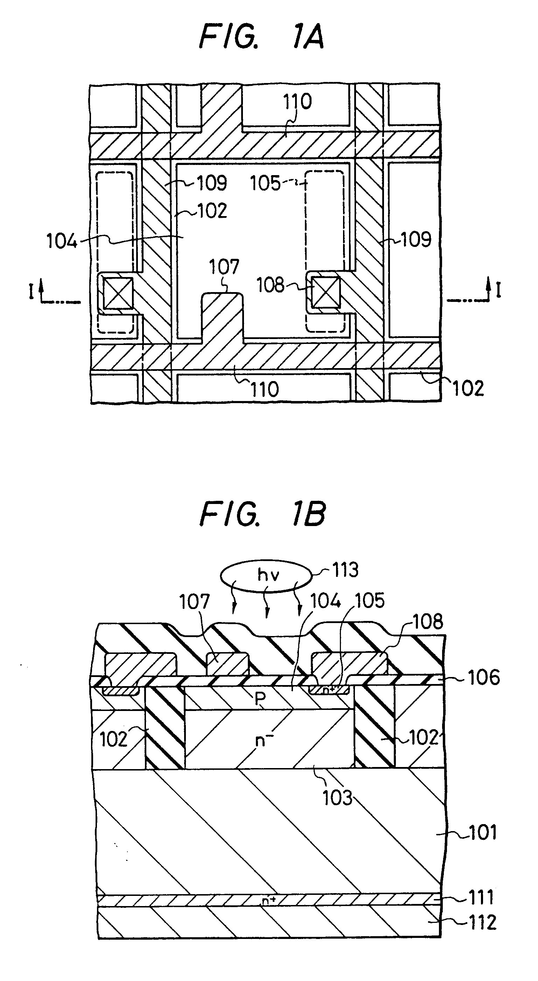

Fig. 1 A is a schematic plan view illustrating a photoelectric conversion device described in the Official Gazette of an EPC laid-open publication No.0132067, and Fig. 1B is a cross section along line I-I of Fig. 1 A .

In the figures, photosensor cells are formed disposed on an $n^+$ silicon substrate 101, each photosensor cell being electrically insulated from adjacent cells by an element isolation region 102 made of, such as $SiO_2$, $Si_3N_4$, or polysilicon.

Each photosensor cell is constructed as in the following:

On an $n^-$ region 103 of low impurity density which is formed by epitaxial technique or the like, there is formed a p region 104 by doping p-type impurities within which p region an $n^+$ region 105 is formed by impurity diffusion technique or ion implantation technique. The p region 104 and $n^+$ region 105 constitute the base and emitter of a bipolar transistor, respectively.

On the p region 104 and $n^+$ region 105 formed on the $n^-$ region 103, there is formed an oxidized film 106 on which a capacitor electrode 107 having a predetermined area is formed. The capacitor electrode 107 faces the p region 104, the oxidized film 106 being interposed therebetween. Thus, by applying a voltage to the capacitor electrode 107, the potential of the p region 104 at a floating state can be controlled.

In addition, there are formed an emitter electrode 108 connected to the $n^+$ region 105, an interconnection 109 for reading a signal from the emitter electrode and outputting it to an external circuit, an $n^+$ region 111 of high impurity density on the back of the substrate, and an electrode 112 for applying a potential to the collector of the bipolar transistor.

Next, the fundamental operation of the above-described photosensor will be described. Light 113 is applied to the p region 104 or the base of the bipolar transistor to thereby store the charge corresponding to light quantity (storage operation). The base potential varies with the stored charge. By reading a potential change from the emitter electrode at a floating state, an electrical signal corresponding to the incident light quantity can be obtained (readout operation). To eliminate the stored charge in the p region 104, the emitter electrode 108 is grounded and the capacitor electrode 107 is applied with a positive pulse voltage (refreshing operation). Since the p region 104 is forward-biased relative to the $n^+$ region 105 by applying the positive pulse voltage, the stored charge is eliminated. The above operations, i.e., storage, readout and refreshment are repeated.

In summary, according to the proposed method, the charge generated by incident light is stored in the p region 104 or the base so that current flowing through the emitter electrode 108 and collector electrode 112 can be controlled. Thus, the stored charge is amplified at each cell and thereafter is read so that a high output and sensitivity as well as a low noise can be achieved.

The base potential $V_p$ generated by the holes stored in the base through light excitation is given by Q/C, wherein Q represents the charge quantity of holes stored in the base, and C represents a capacitance connected to the base. As apparent from the above relationship, a high integration of the photosensor leads to a reduction in cell size as well as a reduction in values of Q and C, so that the potential $V_p$ generated through light excitation is maintained substantially constant. Consequently, the proposed method is considered also effective for high resolution of the photosensor in future.

However, for the above-described, conventional photoelectric conversion device, deep etching is required for forming the element isolation region 102 for electrically insulating each cell, thereby resulting in a problem that the manufacturing process becomes complicated.

Furthermore, this deep etching causes other problems such as an increase in leakage current between cells due to damages of the substrate 101 and due to stress at the interfacial surface between the $n^-$ layer 103 and the isolation region 102.

It is known, e.g. from International Election Devices Meeting 1982, Technical Digest pages 62 to 65, from DE-A-3326924 and from GB-A-1363515 to provide electrical isolation by use of a highly doped semiconductor region. In the first of these disclosures, a channel stop region is formed below an oxide insulation groove. The channel stop region has the same conductivity type as the surrounding material, but has a higher level of doping.

## SUMMARY OF THE INVENTION

According to the invention there is provided a device and a method as set out in the claims.

## BRIEF DESCRIPTION OF THE DRAWINGS

Fig. 1 A is a schematic plan view illustrating a conventional photoelectric conversion device, and Fig. 1 B is a cross section along line I-I of Fig. 1 A;

Fig. 2 A is a plan view showing an embodiment of a photoelectric conversion device according to the present invention, and Figs. 2B and 2C are cross sections of a single cell along line A-A' of Fig. 2A;

Fig. 3 A is a schematic, partial cross section of the embodiment, and Fig. 3 B and 3 C are potential distribution graphs of the embodiment at the vicinity of the element isolation region; and

Figs. 4A to 4L are views illustrating the manufacturing processes of the photoelectric conversion device of the embodiment.

## DETAILED DESCRIPTION OF THE PREFERRED EMBODIMENT

The embodiment of the present invention will now be described in detail with reference to the accompanying drawings.

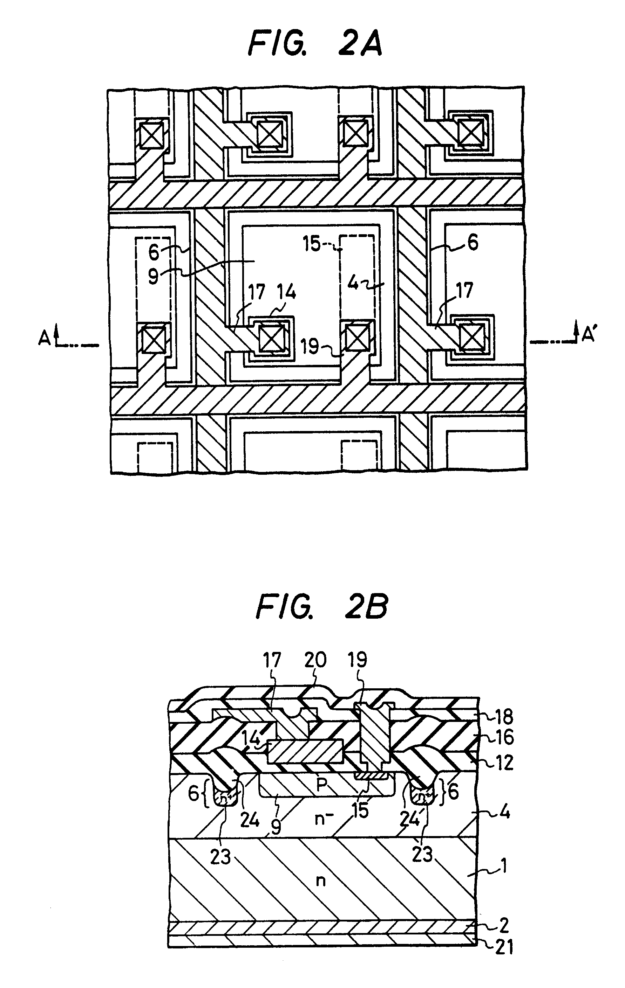

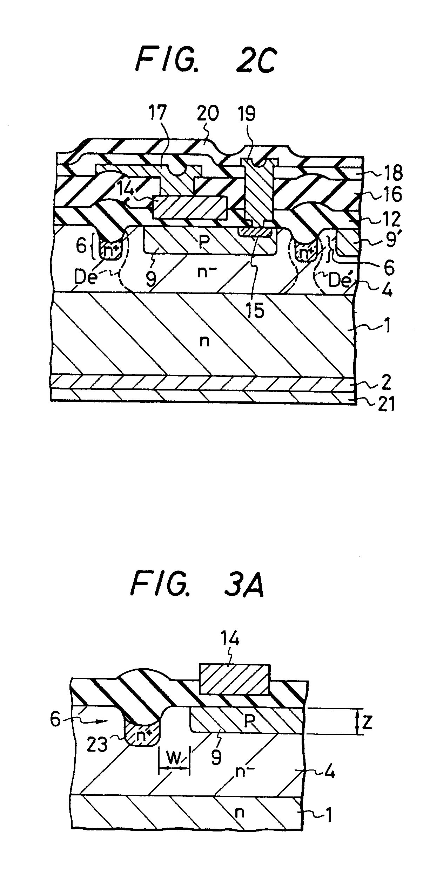

Fig. 2 A is a schematic plan view showing an embodiment of the photoelectric conversion device according to the present invention, and Figs. 2 B and 2 C are cross sections of a single cell along line A-A' of Fig. 2 A .

Referring specifically to Figs. 2 A and 2 B , on an n silicon substrate 1, there is formed an $n^-$ epitaxial layer 4 within which photosensor cells are disposed each electrically insulated by element isolation regions 6. The element isolation region 6 is constructed of a field oxidized film 24 and an $n^+$ region 23 formed underneath the field oxidized film 24. An adequate voltage is applied to the $n^+$ region 23 through an unrepresented electrode, as will be described later.

Each photosensor cell comprises: a p base region 9 and an $n^+$ emitter region 15 of a bipolar transistor formed within the $n^-$ epitaxial region 4; a polysilicon electrode 14 of a capacitor for applying a pulse to the p base region 9 via an oxidized film 12 interposed therebetween; an electrode 19 connected to the $n^+$ emitter region 15; an electrode 17 connected to the polysilicon 14; an $n^+$ region 2 of high impurity density at the back of the substrate 1; and an electrode 21 for applying a potential to the collector of the bipolar transistor.

According to the fundamental operation of this embodiment, the p base region 9 biased to a negative potential is first made into a floating state as described previously, and holes among pairs of electrons and holes are stored in the p base region 9 (storage operation). Succeedingly, the emitter and base are forward-biased to read, from the emitter at a floating state, the storage voltage generated by the stored holes (readout operation). Then, by grounding the emitter and applying a positive pulse voltage to the polysilicon electrode 14 of the capacitor, the stored holes in the p base region 9 are eliminated via the emitter (refreshing operation). By eliminating the stored holes, the p base region 9 resumes an initial condition biased to a negative potential when the refreshing positive pulse voltage falls down.

The widening of a depletion layer De at this initial condition is schematically shown in Fig. 2 C . As shown in the figure, the depletion layer De is not likely to superpose on a depletion layer De' of the adjacent cell due to the presence of the element isolation region 6, thus ensuring a reliable isolation between respective cells.

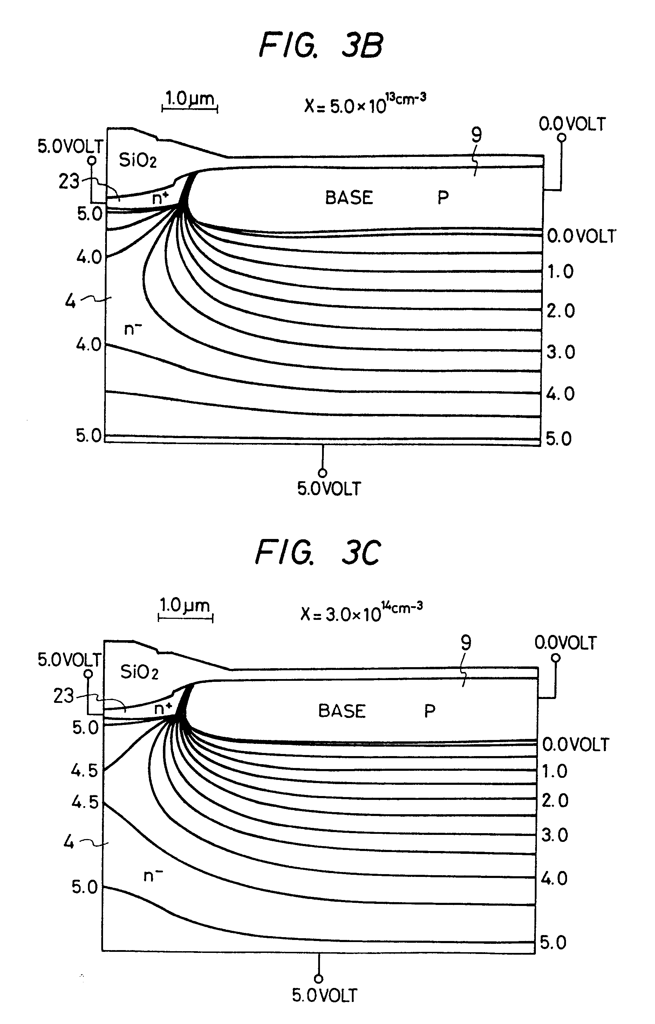

The more detailed explanation will be given with reference to Fig. 3.

Fig. 3 A is a schematic, partial cross section of this embodiment. In the figure, the depth of the p base region 9 is represented by Z, the distance between the p base region 9 and the $n^+$ region 23 is represented by W, and the thickness of the $n^-$ layer 4 is assumed 5 $\mu$m.

In this embodiment, for example, on condition that the density X of the $n^-$ layer 4, the density Y of the $n^+$ region 23 and the depth Z of the p base region 9 are varied, the considerable factors causing the photoelectric conversion device nonoperative are the breakdown voltage between the p base region 9 and the $n^+$ region 23 and the incompleteness of element isolation due to the widening of depletion layers.

An example of distances W affording a satisfactory breakdown voltage is shown in Table, with X, Y and Z varied.

Table

| $X(\times 10^{13} cm^{-3})$ | $Y(\times 10^{17} cm^{-3})$ | $Z(\mu m)$ | $W(\mu m)$ |
|---|---|---|---|
| 30 | 5 | 0.8 | 1.4 or larger |
| 30 | 30 | 0.8 | 1.5 or larger |
| 30 | 5 | 0.6 | 1.2 or larger |
| 5 | 5 | 0.8 | 1.6 or greater |
| 5 | 30 | 0.8 | 1.7 of larger |
| 5 | 5 | 0.6 | 1.4 or larger |

Figs. 3 B and 3 C are potential distribution graphs near the element isolation region of this embodiment, wherein $Y = 5 \times 10^{17} cm^{-3}$ and $W = 1 \mu m$.

As shown in Figs. 3 B and 3 C , by applying the same voltage as that of the collector $n^-$ layer 4 to the $n^+$ region 23, a potential barrier is formed between adjacent cells. Therefore, carriers generated by light do not flow into adjacent cells, thus ensuring a substantial element isolation even if a connection between depletion layers may occur.

Next, the manufacturing processes of this embodiment will described.

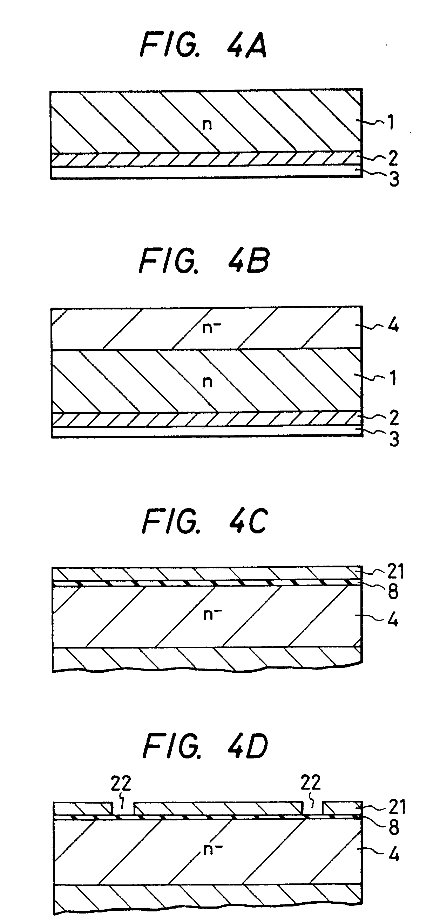

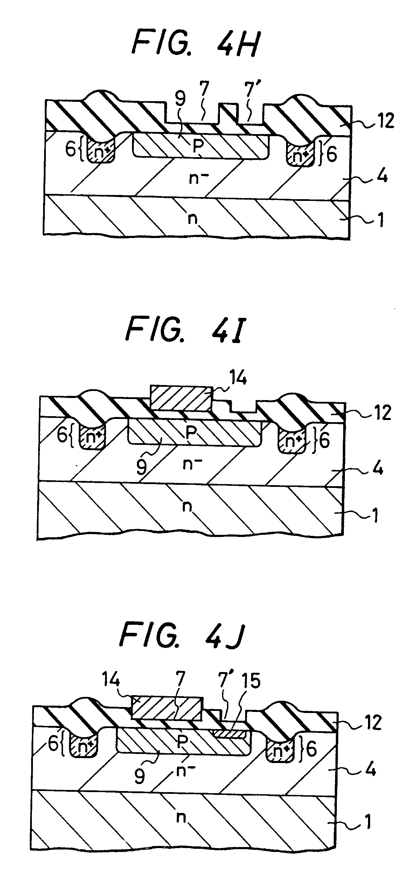

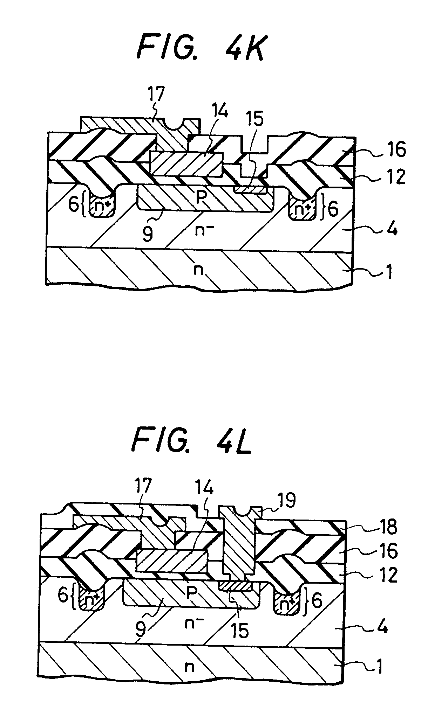

Figs. 4 A to 4 L illustrate the manufacturing processes of this embodiment.

First, as shown in Fig. 4 A , at the back of an n type silicon substrate 1 having an impurity density of 1 x $10^{15}$ to 1 x $10^{18} cm^{-3}$, an $n^+$ layer 2 for use in ohmic contact having an impurity density of 1 x $10^{17}$ to 1 x $10^{20} cm^{-3}$ is formed by diffusing P, As or Sb. Next, on the $n^+$ layer 2 an oxidized film 3 (e.g., $SiO_2$ film) having a thickness of 300 to 700 $\mu m$ (3000 to 7000 Å) is formed by means of a CVD method.

The oxidized film 3, which is called a back coat, is used for preventing impurity vapor from being generated during a heat treatment process of the substrate 1.

Next, the surface of the substrate is etched for about 1.5 minute under the condition of temperature at 1000 °C, 2ℓ/min of HC and 60ℓ/min of $H_2$. Thereafter, an $n^-$ epitaxial layer 4 (hereinafter referred to as $n^-$ layer 4) is formed under the condition of, for example, 1.2ℓ/min of source gas $SiH_2 Cl_2$ (100%), 100cc flow of doping gas (20 PPM $PH_3$ diluted by $H_2$), growing temperature of 100 °C and reduced pressure at 120 to 180 Torr. The monocrystal growing rate is 0.5 m/min, the thickness of the monocrystal is 2 to 10 $\mu m$. The impurity density is 1 x $10^{12}$ to $10^{16} cm^{-3}$, or preferably $10^{12}$ to $10^{14}$ $cm^{-3}$ [Fig. 4 B ].

To improve the quality of the $n^-$ layer 4, it is also very effective to use such a substrate having a denuded zone and capable of undergoing intrinsic gettering. To this end, the substrate is first subjected to a high temperature heat treatment at 1150 to 1250 °C to remove oxygen near at the surface, following a long time heat treatment at about 800 °C to produce plural micro-defects in the substrate.

Next, on the $n^-$ layer 4 a pad oxidized film 8 of 50 to 150 $\mu m$ (500 to 1500 Å) thickness is formed by means of pyrogenic oxidation ($H_2$ + $O_2$) wet oxidation ($O_2$ + $H_2O$), steam oxidation ($N_2$ + $H_2O$) or dry oxidation. To obtain a good oxidized film without lamination defects, a high pressure oxidation at temperature of 800 to 1000 °C is preferable.

Thereafter, a nitride film ($Si_3N_4$) 21 of 100 to 200 $\mu m$ (1000 to 2000 Å) thickness is deposited by means of an LPCVD method or P-CVD method [Fig. 4 C] .

In this example, the LPCVD method was employed under the condition of deposition temperature of 770 to 830 °C, degree of vacuum at 0.1 to 0.3 Torr, 20 to 30 SCCM of $SiH_2 Cl_2$, and 70 to 150 SCCM of $NH_3$, which led to a good result.

Next, the nitride film 21 located where an element isolation region 6 is to be formed is selectively removed by means of a dry etching method to form an opening 22 [Fig. 4 D ].

Succeedingly, impurity ions such as As or P are implanted into the $n^-$ region 4 by means of an ion implantation method, using the nitride film 21 as a mask.

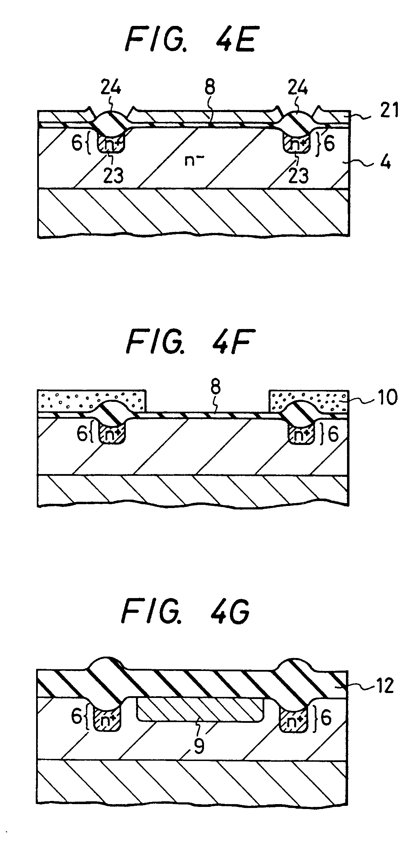

Next, after electrically activating through heat treatment under $N_2$ atmosphere, a thick field oxidized film 24 is selectively formed at the opening 22 of the nitride film 21 by means of a LOCOS oxidation method, and the $n^+$ region 23 is formed down to a predetermined depth. Consequently, an element isolation region 6 including the $n^+$ region 23 is formed beneath the field oxidized film 24 [Fig. 4 E ].

Next, the nitride film 21 is completely removed with heated phosphoric acid to expose the oxidized film 8 and the field oxidized film 24. The oxidized film 8 is provided for preventing channeling and surface defects during the process for forming a base region through ion implantation. In the above process, the back coat oxidized film 3 is completely removed.

Succeedingly, a resist 10 is coated, the part of which where the base region is formed is selectively removed [Fig. 4 F ].

Next, $B^+$ ions or $BF_2^+$ ions produced using $BF_3$ as material gas are implanted into the wafer. The surface density thereof is 1 x $10^{15}$ to 5 x $10^{18}$ cm$^{-3}$, or preferably 1 to 20 x $10^{16}$ cm$^{-3}$, while the doping amount of ions is 7 x $10^{11}$ to 1 x $10^{15}$ cm$^{-2}$, or preferably 1 x $10^{12}$ to 1 x $10^{14}$ cm$^{-2}$.

After the ion-implantation and removal of the resist 10, the p base region 9 is formed down to a predetermined depth through heat diffusion under the condition of 1000 to 1100 °C and $N_2$ atmosphere, and at the same time a thick oxidized film 12 is formed on the surface of the substrate 1 [Fig. 4 G ].

The depth of the p base region 9 is 0.6 to 1 $\mu$m for example. The depth and impurity density are determined on the basis of the following technical concept.

To obtain a high sensitivity, it is desirous to make the base-emitter capacitance Cbe smally by lowering the impurity density of the p base region 9. Cbe is given approximately by the following formula:

$$Cbe \; = \; Ae \, \epsilon \, ( \frac{q \; \cdot \; N_A}{2 \, \epsilon Vbi} )^{1/2}$$

wherein Vbi is a diffusion potential between the emitter and the base which is given by:

$$Vbi \; = \; \frac{kT}{q} 1 \; n \frac{N_A N_D}{ni^2}$$

wherein $\epsilon$ is a dielectric constant of silicon crystal, $N_D$ is an impurity density of the emitter, $N_A$ is an impurity density of the base near the emitter region, $n_i$ is an intrinsic carrier density, Ae is an area of the base region, k is the Boltzmann constant, T is an absolute temperature, and q is a unit electric charge. The sensitivity can be made higher the smaller $N_A$ is made and hence the smaller Cbe is made. However, if $N_A$ is made too small, the base region is completely depleted under operation and takes a punch-through state. Therefore, $N_A$ cannot be made too small. For this reason, $N_A$ is set at a proper value that the base region cannot completely be depleted and does not take a punch-through state.

An alternative method of forming the base region 9 is to deposit BSG on the wafer and diffuse impurity B down to a predetermined depth through heat treatment at 1100 to 1200 °C.

Next, the parts of the oxidized film 12 are selectively removed where the capacitor electrode and the emitter region are formed. In the openings thus formed, a gate oxidized film 7 and an oxidized film 7' are formed to the thickness of 10 to 100 $\mu$m (100 to 1000 Å) [Fig. 4 H ].

Thereafter, polysilicon with As doped is deposited by means of a CVD method using ($N_2$ + $SiH_4$ + $AsH_3$) gas or ($H_2$ + $SiH_4$ + $AsH_3$) gas. The deposition temperature is about 550 to 900 °C and the thickness is 200 to 700 $\mu$m (2000 to 7000 Å). Obviously, it is also possible to deposit non-doped polysilicon by means of a CVD method and thereafter diffuse As or P. The deposited polysilicon film is partially etched by means of a photolithography process to form a polysilicon electrode 14 [Fig. 4 I ].

Next, impurity ions such as P or As are ion-implanted through the oxidized film 7' into the area where an emitter region is formed. After heat treatment, an $n^+$ region 15 is formed [Fig. 4 J ].

In this embodiment although the $n^+$ emitter region 15 is formed by means of an ion implantation method, the emitter region 15 may be formed in such a way that the oxidized film 7' is removed, in the opening thus obtained polysilicon is deposited at the process forming the polysilicon 14, and impurity such as P or As in the polysilicon is diffused into the p base region 9 through heat treatment to form the emitter region.

Next, a PSG film or $SiO_2$ film 16 is deposited by means of a CVD method using the above-described gas to the thickness of 30 to 700 $\mu$m (300 to 7000 Å). Succeedingly, a contact hole is formed on the polysilicon by mask alignment and etching processes. An electrode 17 (metal such as Al, Al-Si, Al-Cu-Si) is deposited in the contact hole by means of a vacuum evaporation or sputtering method [Fig. 4 K ].

Succeedingly, an interlayer insulation film 18 such as PSG film or $SiO_2$ film is deposited to the thickness of 300 to 900 $\mu$m (3000 to 9000 Å) by means of a CVD method. A contact hole is formed on the emitter region 15 by mask alignment and etching processes to form an electrode 19 (metal such as Al, Al-Si, Al-Cu-Si) [Fig. 4 L ].

Lastly, a passivation film 20 (such as PSG film or $Si_3N_4$ film) is formed by means of a CVD method and thereafter, and electrode 21 (metal such as Al, Al-Si, Au) is formed at the back of the wafer. Thus, a photoelectric conversion device as shown in Figs. 2 A and 2 B is manufactured.

In this embodiment, although the semiconductor region beneath the oxidized film 24 of the element isolation region 6 uses an $n^+$ semiconductor, the present invention is not limited to this conduction type but a $p^+$ semiconductor is also applicable in case of a PNP bipolar transistor.

As seen from the foregoing detailed description of the photoelectric conversion device of the present invention, the isolation region for electrically insulating each cell is constructed of an insulation region and a semiconductor region formed beneath the insulation region. In addition, the semiconductor region has the same conductive type as that of the main electrode regions of the semiconductor transistor. As a result, a semiconductor region of high impurity density is formed at an area deep in the isolation region so that the electrical insulation effect for each cell is enhanced.

Furthermore, it is not necessary to form an isolation region made of insulated material by using conventional, complicated processes, but it is possible to form an isolation region with ease by employing ordinary methods such as a selective oxidation method and an implantation method, thereby enabling a high integration of the device.

Still further, since the insulation region of the isolation region may be made of oxidized material formed by selective oxidation, the isolation region can be formed without etching processes. Therefore, the manufacturing processes are simplified. In addition, semiconductor crystal is not subjected to damages so that leakage current between cells and the like are reduced to thereby stabilize the operation of each cell.

## Claims

1. A photoelectric conversion device having a plurality of photoelectric conversion cells, each cell having a bipolar semiconductor transistor comprising a base region (9) of a first conductivity type, an emitter region (15) of a second conductivity type, a collector region (1,4) of the second conductivity type, and a control electrode (14) capacitively coupled to the base region (9), the base region (9) storing photo-carriers induced by incident light while being electrically floating, wherein, by forward biasing the junction between the base and emitter regions, reading of an output signal in accordance with the amount of said incident light is conducted, the collector region having an upper side toward the base region and a lower side away from the base region and comprising a low doped layer (4) adjacent the base region (9), the device further having an isolation region (6) for electrically isolating adjacent said photoelectric conversion cells, the isolation region comprising an insulating portion (24) between the cells,

   characterised in that the isolation region further comprises a high impurity concentration portion (23) of the second conductivity type under the insulating portion and within said low doped layer (4), said high impurity concentration portion (23) having an impurity concentration higher than that of said low doped layer (4), the same voltage being applied to said high impurity concentration portion and to the low doped layer (4) so that a potential barrier is formed between adjacent cells.

2. A device according to claim 1, in which the base region (9) is provided within the said low doped layer (4).

3. A device according to claim 1 or claim 2, in which the high impurity concentration portion (23) has an impurity concentration of $5 \times 10^{17}$ to $3 \times 10^{18}$ $cm^{-3}$.

4. A device according to any one of claims 1 to 3 in which the low doped layer (4) has an impurity concentration of $1 \times 10^{12}$ to $1 \times 10^{16}$ $cm^{-3}$.

5. A device according to claim 4, in which the said low doped layer (4) has an impurity concentration of $5 \times 10^{13}$ to $3 \times 10^{14}$ $cm^{-3}$.

6. A device according to any one of claims 1 to 5 in which the collector region further comprises a second layer (1), of the same conductivity type as the low doped layer (4), but having a greater impurity concentration.

**7.** A device according to any one of the preceding claims, in which the base region (9) is spaced from high impurity concentration portion (23) by at least 1.2μm.

**8.** A device according to any one of the preceding claims in which the base region is 0.6 to 1.0 μm thick.

**9.** A device according to any one of the preceding claims in which the low doped layer (4) is 2 to 10μm thick.

**10.** A method of electrically isolating photoelectric conversion cells in a photoelectric conversion device, the device having a plurality of cells and each cell having a transistor comprising a base region (9) of a first conductivity type, an emitter region (15) and a collector region (1,4) both of a second conductivity type and a control electrode (14) capacitively coupled to the base region (9), carriers generated by incident light being stored in the said base region (9) while it is electrically floating and an output signal being obtainable in accordance with the stored charge in the base region (9), the device further having electrical isolation means (6) between adjacent said cells which isolation means comprises an electrically insulating region (24)

characterised in that

the electrical isolation means (6) further comprises a further semiconductor region (23) below the electrically insulating region (24), the further semiconductor region (23) being of the second conductivity type, extending into a layer (4) of the collector region ( 1, 4) and having an impurity concentration higher than that of the layer (4) of the collector region,

and the method comprising applying the same voltage to the further semiconductor region (23) and to the layer (4) so that a potential barrier is formed between adjacent cells.

**11.** A method according to claim 10, in which the junction between the base (9) and emitter (15) regions is reverse-biased during a charge accumulation period in which the control region is electrically floating and the light induced carriers are stored in the base region.

**12.** A method according to claim 10 or claim 11 in which said collector region comprises a first layer (4), within which the further semiconductor region (23) is formed, and a second layer (1) adjacent to the first layer (4), the first and second layers being of the same conductivity type as each other but the second layer having a higher impurity concentration.

**Patentansprüche**

**1.** Fotoelektrische Wandlervorrichtung mit einer Vielzahl von fotoelektrischen Wandlerzellen, von denen jede einen bipolaren Halbleitertransistor mit einer Basiszone (9) eines ersten Leitungstyps. einer Emitterzone (15) eines zweiten Leitungstyps, einer Kollektorzone (1, 4) des zweiten Leitungstyps und einer Steuerelektrode (14) hat, die kapazitiv mit der Basiszone (9) gekoppelt ist, welche durch einfallendes Licht induzierte Foto-Ladungsträger speichert, während sie elektrisch anschlußfrei ist, wobei durch Vorwärts-Vorspannung des Übergangs zwischen der Basiszone und der Emitterzone ein der einfallenden Lichtmenge entsprechendes Ausgangssignal ausgelesen wird, die Kollektorzone eine der Basiszone zugewandte Oberseite und eine von der Basiszone abgewandte Unterseite hat und angrenzend an die Basiszone (9) eine niedrig dotierte Schicht (4) enthält und die Vorrichtung ferner zum elektrischen Isolieren benachbarter fotoelektrischer Wandlerzellen eine Isolierzone (6) hat, die einen isolierenden Abschnitt (24) zwischen den Zellen hat,

dadurch gekennzeichnet, daß die Isolierzone ferner unter dem isolierenden Abschnitt und in der niedrig dotierten Schicht (4) einen Abschnitt (23) hoher Störstellenkonzentration enthält, der eine Störstellenkonzentration hat, die höher als diejenige der niedrig dotierten Schicht (4) ist, wobei an den Abschnitt hoher Störstellenkonzentration und die niedrig dotierte Schicht (4) die gleiche Spannung angelegt ist, so daß zwischen benachbarten Zellen eine Potentialschwelle gebildet ist.

**2.** Vorrichtung nach Anspruch 1, in der die Basiszone (9) in der niedrig dotierten Schicht (4) gebildet ist.

**3.** Vorrichtung nach Anspruch 1 oder Anspruch 2, in der der Abschnitt (23) hoher Störstellenkonzentration eine Störstellenkonzentration von $5 \times 10^{17}$ bis $3 \times 10^{18}$ cm$^{-3}$ hat.

**4.** Vorrichtung nach einem der Ansprüche 1 bis 3, in der die niedrig dotierte Schicht (4) eine Störstellenkonzentration von 1 x $10^{12}$ bis 1 x $10^{16}$ cm$^{-3}$ hat.

**5.** Vorrichtung nach Anspruch 4, in der die niedrig dotierte Schicht (4) eine Störstellenkonzentration von 5 x $10^{13}$ bis 3 x $10^{14}$ cm$^{-3}$ hat.

**6.** Vorrichtung nach einem der Ansprüche 1 bis 5, in der die Kollektorzone ferner eine zweite Schicht (1) enthält, die vom gleichen Leitungstyp wie die niedrig dotierte Schicht (4) ist, aber eine größere Störstellenkonzentration hat.

**7.** Vorrichtung nach einem der vorangehenden Ansprüche, in der die Basiszone (9) um mindestens 1,2 μm von dem Abschnitt (23) hoher Störstellenkonzentration beabstandet ist.

**8.** Vorrichtung nach einem der vorangehenden Ansprüche, in der die Basiszone 0,6 bis 1,0 μm dick ist.

**9.** Vorrichtung nach einem der vorangehenden Ansprüche, in der die niedrig dotierte Schicht (4) 2 bis 10 μm dick ist.

**10.** Verfahren zum elektrischen Isolieren von fotoelektrischen Wandlerzellen in einer fotoelektrischen Wandlervorrichtung, die eine Vielzahl von Zellen hat, von denen jede einen Transistor mit einer Basiszone (9) eines ersten Leitungstyps, einer Emitterzone (15) und einer Kollektorzone (1, 4), die beide von einem zweiten Leitungstyp sind, und einer Steuerelektrode (14) hat, die kapazitiv mit der Basiszone (9) gekoppelt ist, wobei in der Basiszone (9) durch einfallendes Licht erzeugte Ladungsträger gespeichert werden, wenn sie elektrisch anschlußfrei ist, und entsprechend der gespeicherten Ladung in der Basiszone ein Ausgangssignal erzielbar ist, wobei die Vorrichtung ferner zwischen benachbarten Zellen eine elektrische Isoliervorrichtung (6) hat, die eine elektrisch isolierende Zone (24) enthält,
    dadurch gekennzeichnet, daß
    die elektrische Isoliereinrichtung (6) ferner unterhalb der elektrisch isolierenden Zone (24) eine weitere Halbleiterzone (23) enthält, die von dem zweiten Leitungstyp ist, sich in eine Schicht (4) der Kollektorzone (1, 4) erstreckt und eine Störstellenkonzentration hat, die höher als diejenige der Schicht (4) der Kollektorzone ist, und das Verfahren das Anlegen der gleichen Spannung an die weitere Halbleiterzone (23) und die Schicht (4) umfaßt, so daß zwischen benachbarten Zellen eine Potentialschwelle gebildet wird.

**11.** Verfahren nach Anspruch 10, bei dem der Übergang zwischen der Basiszone (9) und der Emitterzone (15) in Sperrichtung während einer Ladungssammelperiode vorgespannt wird, in der die Steuerungszone elektrisch anschlußfrei und die durch das Licht induzierten Ladungsträger in der Basiszone gespeichert werden.

**12.** Verfahren nach Anspruch 10 oder Anspruch 11, bei dem die Kollektorzone eine erste Schicht (4), in der die weitere Halbleiterzone (23) ausgebildet ist, und eine an die erste Schicht (4) angrenzende zweite Schicht (1) aufweist, wobei die erste und die zweite Schicht vom einander gleichen Leitfähigkeitstyp sind, aber die zweite Schicht eine höhere Störstellenkonzentration hat.

## Revendications

**1.** Dispositif de conversion photoélectrique ayant plusieurs cellules de conversion photoélectrique, chaque cellule ayant un transistor semiconducteur bipolaire comprenant une région de base (9) d'un premier type de conductivité, une région d'émetteur (15) d'un second type de conductivité, une région de collecteur (1, 4) du second type de conductivité et une électrode de commande (14) en couplage capacitif avec la région de base (9), la région de base (9) emmagasinant des photoporteurs induits par une lumière incidente tout en étant électriquement flottante, dispositif dans lequel, en polarisant dans le sens direct la jonction entre les régions de base et d'émetteur, on effectue la lecture d'un signal de sortie correspondant à la quantité de ladite lumière incidente, la région de collecteur ayant un côté supérieur vers la région de base et un côté inférieur éloigné de la région de base et comportant une couche faiblement dopée (4) adjacente à la région de base (9), le dispositif ayant en outre une région d'isolation (6) pour isoler électriquement lesdites cellules de conversion photoélectrique adjacentes, la région d'isolation comportant une partie isolante (24) entre les cellules,

caractérisé en ce que la région d'isolation comporte en outre une partie (23) à haute concentration d'impuretés du second type de conductivité sous la partie isolante et dans ladite couche faiblement dopée (4), ladite partie (23) à haute concentration d'impuretés ayant une concentration d'impuretés supérieure à celle de ladite couche faiblement dopée (4), la même tension étant appliquée à ladite partie à haute concentration d'impuretés et à la couche faiblement dopée (4) afin qu'une barrière de potentiel soit formée entre des cellules adjacentes.

2. Dispositif selon la revendication 1, dans lequel la région de base (9) est prévue à l'intérieur de ladite couche faiblement dopée (4).

3. Dispositif selon la revendication 1 ou la revendication 2, dans lequel la partie (23) à haute concentration d'impuretés possède une concentration d'impuretés de $5 \times 10^{17}$ à $3 \times 10^{18}$ cm$^{-3}$.

4. Dispositif selon l'une quelconque des revendications 1 à 3, dans lequel la couche faiblement dopée (4) possède une concentration d'impuretés de $1 \times 10^{12}$ à $1 \times 10^{16}$ cm$^{-3}$.

5. Dispositif selon la revendication 4, dans lequel ladite couche faiblement dopée (4) possède une concentration d'impuretés de $5 \times 10^{13}$ à $3 \times 10^{14}$ cm$^{-3}$.

6. Dispositif selon l'une quelconque des revendications 1 à 5, dans lequel la région de collecteur comprend en outre une seconde couche (1) du même type de conductivité que la couche faiblement dopée (4), mais ayant une plus grande concentration d'impuretés.

7. Dispositif selon l'une quelconque des revendications précédentes, dans lequel la région de base (9) est espacée de la partie (23) à haute concentration d'impuretés d'au moins 1,2 $\mu$m.

8. Dispositif selon l'une quelconque des revendications précédentes, dans lequel la région de base a une épaisseur de 0,6 à 1,0 $\mu$m.

9. Dispositif selon l'une quelconque des revendications précédentes, dans lequel la couche faiblement dopée (4) a une épaisseur de 2 à 10 $\mu$m.

10. Procédé pour isoler électriquement des cellules de conversion photoélectrique dans un dispositif de conversion photoélectrique, le dispositif ayant plusieurs cellules et chaque cellule ayant un transistor comprenant une région de base (9) d'un premier type de conductivité, une région d'émetteur (15) et une région de collecteur (1, 4), toutes deux d'un second type de conductivité et une électrode de commande (14) en couplage capacitif avec la région de base (9), les porteurs générés par une lumière incidente étant emmagasinés dans ladite région de base (9), tandis qu'elle est électriquement flottante, et un signal de sortie pouvant être obtenu en fonction de la charge emmagasinée dans la région de base (9), le dispositif ayant en outre un moyen (6) d'isolation électrique entre lesdites cellules adjacentes, lequel moyen d'isolation comporte une région électriquement isolante (24),
caractérisé en ce que
le moyen d'isolation électrique (6) comprend en outre une autre région semiconductrice (23) au-dessous de la région électriquement isolante (24), l'autre région semiconductrice (23) étant du second type de conductivité, pénétrant dans une couche (4) de la région de collecteur (1, 4) et ayant une concentration d'impuretés plus élevée que celle de la couche (4) de la région de collecteur,
et le procédé consistant à appliquer la même tension à l'autre région semiconductrice (23) et à la couche (4) afin qu'une barrière de potentiel soit formée entre des cellules adjacentes.

11. Procédé selon la revendication 10, dans lequel la jonction entre les régions de base (9) et d'émetteur (15) est polarisée en sens inverse durant une période d'accumulation de charges au cours de laquelle la région de commande est électriquement flottante et les porteurs induits par la lumière sont emmagasinés dans la région de base.

12. Procédé selon la revendication 10 ou la revendication 11, dans lequel ladite région de collecteur comprend une première couche (4) à l'intérieur de laquelle l'autre région semiconductrice (23) est formée et une seconde couche (1) adjacente à la première couche (4), les première et seconde couches étant du même type de conductivité, mais la seconde couche ayant une concentration d'impuretés plus élevée.

## FIG. 1A

## FIG. 1B

# FIG. 2A

# FIG. 2B

# FIG. 2C

# FIG. 3A

## FIG. 3B

1.0μm    $X = 5.0 \times 10^{13} cm^{-3}$

5.0VOLT
SiO₂    9    0.0VOLT
23    n⁺    BASE    P    0.0VOLT
5.0    1.0
4.0    2.0
4    3.0
n⁻    4.0
4.0    5.0
5.0
5.0VOLT

## FIG. 3C

1.0μm    $X = 3.0 \times 10^{14} cm^{-3}$

5.0VOLT
SiO₂    9    0.0VOLT
23    n⁺    BASE    P    0.0VOLT
5.0    1.0
4.5    2.0
4.5    3.0
4    4.0
n⁻    5.0
5.0
5.0VOLT

## FIG. 4A

n — 1
— 2
— 3

## FIG. 4B

$n^-$ — 4
n — 1
— 2
— 3

## FIG. 4C

— 21
— 8
$n^-$ — 4

## FIG. 4D

22          22
— 21
— 8
$n^-$ — 4

## FIG. 4E

## FIG. 4F

## FIG. 4G

## FIG. 4H

## FIG. 4I

## FIG. 4J

17

## FIG. 4K

## FIG. 4L